# EUROPEAN PATENT APPLICATION

(11) **EP 4 277 446 A2**
(43) Date of publication of application: **15.11.2023**
(21) Application number: 22752977.3
(22) Date of filing: 09.02.2022
(51) Int. Cl.: H05K 9/00, H05K 5/03, H04M 1/02, H05K 5/00

(54) **ELECTRONIC DEVICE COMPRISING CONDUCTIVE MEMBER**

(30) Priority: 10.02.2021 KR 20210018877
(71) Applicant: Samsung Electronics Co., Ltd., Suwon-si, Gyeonggi-do 16677 (KR)
(72) Inventor: KIM, Yongyoun, Suwon-si Gyeonggi-do 16677 (KR)
(74) Representative: HGF
(86) International application number: PCT/KR2022/001974
(87) International publication number: WO 2022/173217

(57) **Abstract**

An electronic device comprising a conductive member comprises: a side frame surrounding a space between a first surface and a second surface that is parallel to the first surface; a first metal frame and a second metal frame disposed at the side frame; a segment unit disposed between the first metal frame and the second metal frame; a flexible display disposed on the first surface; a protective cover which is disposed in the direction extending from a side surface toward the first surface, and which covers at least a part of the flexible display; and a conductive member disposed on the surface of the protective cover facing the flexible display, wherein the conductive member can have a segmented region corresponding to the segment unit, and include a first tip part and a second tip part capable of transmitting electric charge.

## Description

### [Technical Field]

Various embodiments of the disclosure relate to an electronic device including a conductive member.

### [Background Art]

Electronic devices are gradually becoming thinner and are being improved to increase rigidity thereof, to strengthen design aspects thereof, and to differentiate functional elements thereof. Electronic devices are gradually being transformed from a uniform rectangular shape into various shapes. The electronic device may have a transformable structure capable of using a large screen display while being convenient to carry. For example, as part of a transformable structure, the electronic device may include at least two foldable housings operating in a folding or unfolding manner relative to each other and supporting a flexible display.

### [Disclosure of Invention]

### [Technical Problem]

Various embodiments of the disclosure provide an electronic device including a conductive member and for discharging static electricity introduced from the outside.

### [Solution to Problem

According to various embodiments, an electronic device including a conductive member may include a side frame configured to enclose a space between a first surface and a second surface parallel to the first surface; a first metal frame and second metal frame disposed at the side frame; a segment part disposed between the first metal frame and the second metal frame; a flexible display disposed on the first surface; a protection cover disposed in a direction extended from the side surface toward the first surface and configured to cover at least a portion of the flexible display; and a conductive member disposed at a surface at which the protection cover faces the flexible display, wherein the conductive member may include a first sharp end and second sharp end segmented in an area corresponding to the segment part and capable of transferring electric charges.

According to various embodiments, an electronic device including a conductive member may include a flexible display; a support plate configured to support the flexible display; a side plate configured to enclose the support plate; a first metal frame and second metal frame disposed at the side frame; a segment part having an insulating property and disposed between the first metal frame and the second metal frame; a protection cover disposed in a direction extended from the side surface toward the first surface and configured to cover at least a portion of the flexible display; and a conductive member disposed at a surface at which the protection cover faces the flexible display, wherein the conductive member may include a first sharp end and second sharp end segmented in an area corresponding to the segment part and capable of transferring electric charges.

### [Advantageous Effects of Invention]

An electronic device including a conductive member according to various embodiments of the disclosure can prevent a coupling phenomenon and discharge static electricity introduced from the outside by segmenting the conductive member to correspond to an antenna segment area.

### [Brief Description of Drawings]

In connection with the description of the drawings, the same or similar reference numerals may be used for the same or similar elements.
FIG. 1A is a perspective view of a front surface of an electronic device illustrating a flat state or unfolding state according to various embodiments of the disclosure.
FIG. 1B is a plan view illustrating a front surface of an electronic device in an unfolding state according to various embodiments of the disclosure.
FIG. 1C is a plan view illustrating a rear surface of an electronic device in an unfolding state according to various embodiments of the disclosure.
FIG. 2A is a perspective view of an electronic device illustrating a folding state according to various embodiments of the disclosure.
FIG. 2B is a perspective view of an electronic device illustrating an intermediate state according to various embodiments of the disclosure.
FIG. 3 is a block diagram illustrating an electronic device in a network environment according to various embodiments.
FIG. 4 is a diagram specifically illustrating an area 401 in FIG. 1A according to various embodiments.
FIG. 5 is a diagram specifically illustrating an area 401 in FIG. 1A according to various embodiments.
FIG. 6 is a diagram specifically illustrating an area 401 in FIG. 1A according to various embodiments.
FIG. 7 is a diagram specifically illustrating an area 401 in FIG. 1A according to various embodiments.
FIG. 8 is a diagram illustrating an area obtained by cutting the electronic device of FIG. 4 in a C1-C2 direction.
FIG. 9 is a diagram illustrating an area obtained by cutting the electronic device of FIG. 7 in a C3-C4 direction.
FIG. 10 is a diagram illustrating a second side frame according to various embodiments of the disclosure.
FIG. 11 is a table illustrating electro static discharge (ESD) test results according to various embodiments of the disclosure.

### [Mode for the Disclosure]

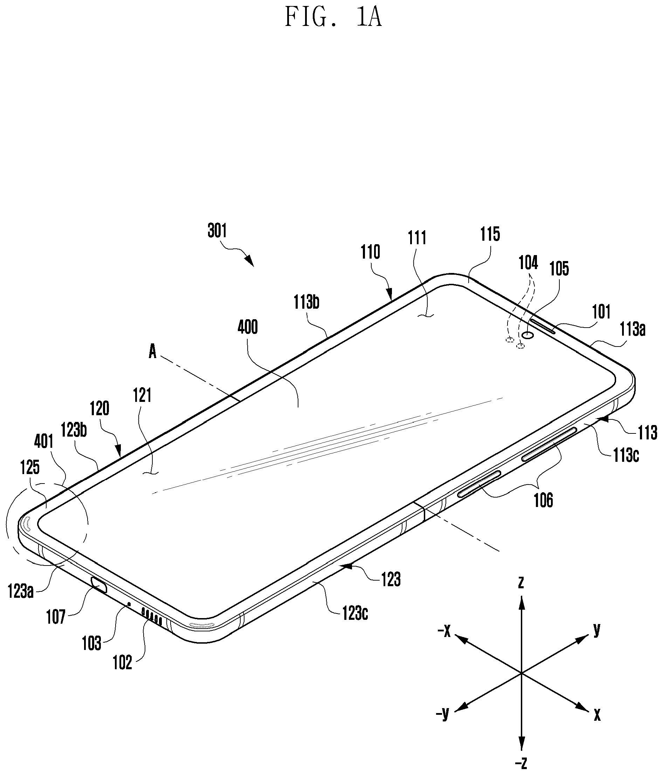

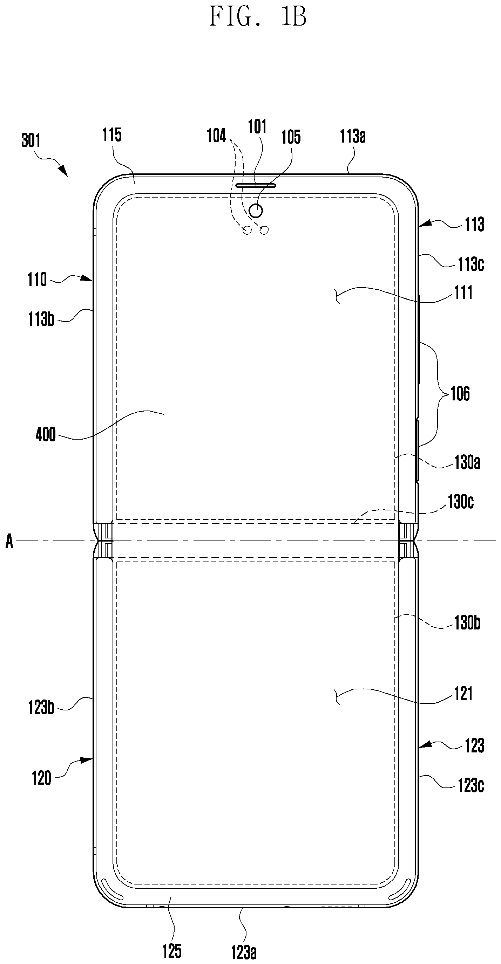

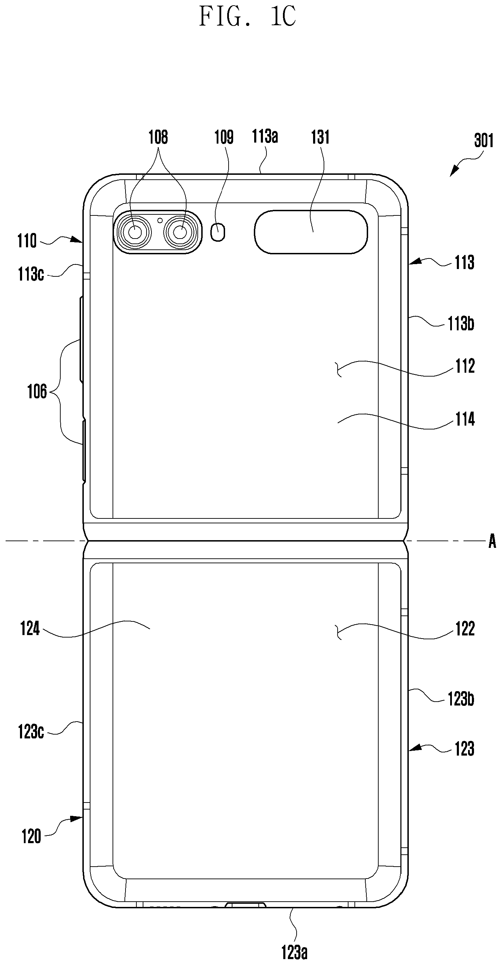

FIG. 1A is a perspective view of an electronic device illustrating a flat state or unfolding state according to various embodiments of the disclosure. FIG. 1B is a plan view illustrating a front surface of an electronic device in an unfolding state according to various embodiments of the disclosure. FIG. 1C is a plan view illustrating a rear surface of an electronic device in an unfolding state according to various embodiments of the disclosure.

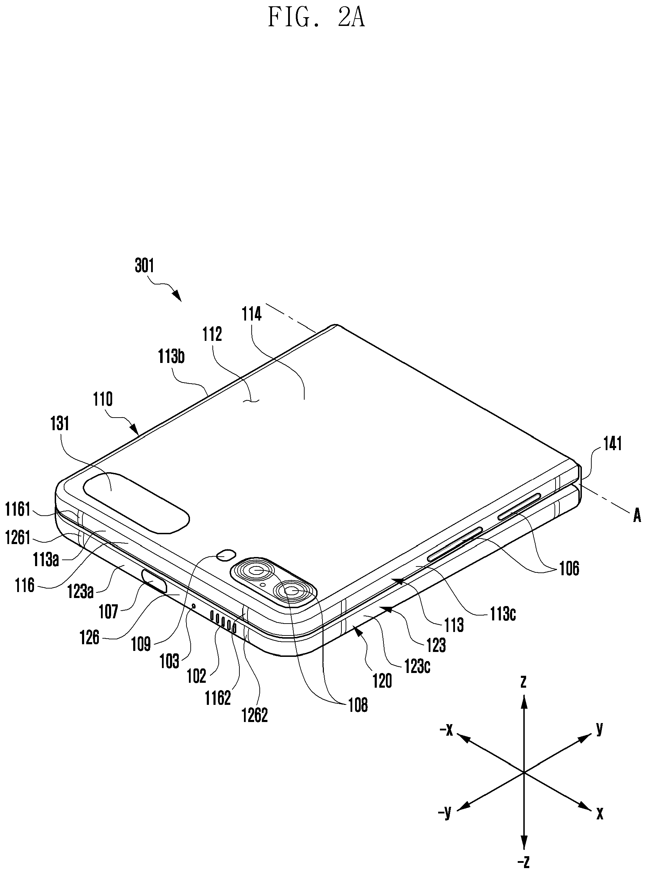

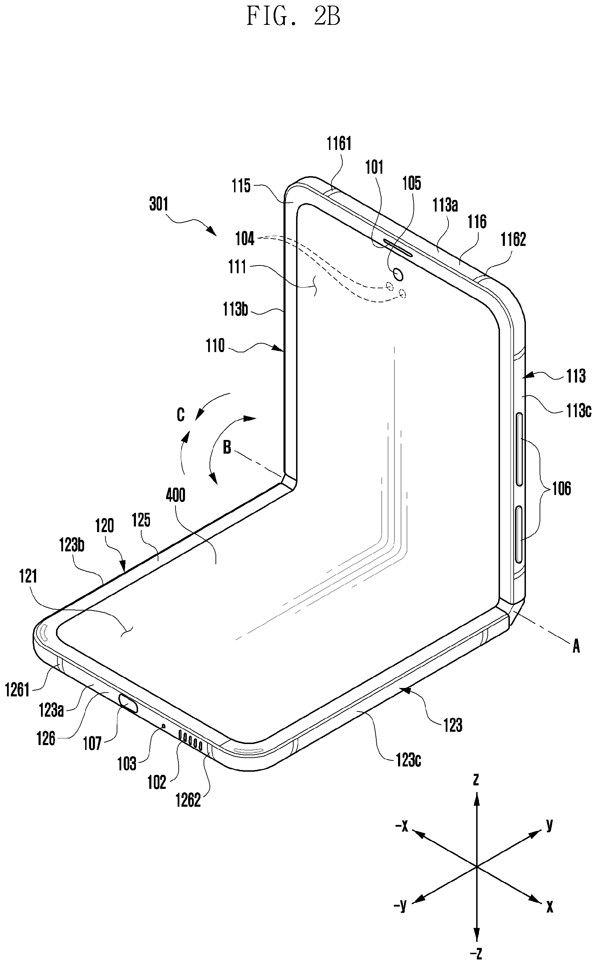

FIG. 2A is a perspective view of an electronic device illustrating a folding state according to various embodiments of the disclosure. FIG. 2B is a perspective view of an electronic device illustrating an intermediate state according to various embodiments of the disclosure.

With reference to FIGS. 1A and 2B, an electronic device 301 may include a pair of housings 110 and 120 (e.g., foldable housing) rotatably coupled to be folded while facing each other based on a hinge module. According to an embodiment, the electronic device 301 may include a flexible display 400 (e.g., foldable display or second display) disposed in an area formed by the pair of housings 110 and 120. According to an embodiment, the first housing 110 and the second housing 120 may be disposed at both sides of a folding axis (axis A) and have substantially symmetrical shapes with respect to the folding axis (axis A). According to an embodiment, the first housing 110 and the second housing 120 may vary an angle or distance therebetween according to whether a state of the electronic device 301 is a flat state or unfolding state, a folding state, or an intermediate state.

According to various embodiments, the pair of housings 110 and 120 may include a first housing 110 (e.g., first housing structure) coupled with a hinge module and a second housing 120 (e.g., second housing structure) coupled with the hinge module. According to an embodiment, in the unfolding state, the first housing 110 may include a first surface 111 facing a first direction (e.g., front direction) (z-axis direction) and a second surface 112 facing a second direction (e.g., rear direction) (-z axis direction) opposite to the first surface 111. According to an embodiment, in an unfolding state, the second housing 120 may include a third surface 121 facing the first direction (z-axis direction) and a fourth surface 122 facing in the second direction (-z-axis direction). According to an embodiment, in the unfolding state of the electronic device 301, the first surface 111 of the first housing 110 and the third surface 121 of the second housing 120 may face substantially the same first direction (z-axis direction), and in a folding state thereof, the first surface 111 and the third surface 121 may operate in a facing manner with respect to each other. According to an embodiment, in the unfolding state of the electronic device 301, the second surface 112 of the first housing 110 and the fourth surface 122 of the second housing 120 may face substantially the same second direction (-z-axis direction), and in a folding state thereof, the second surface 112 and the fourth surface 122 may face opposite directions. For example, in a folding state, the second surface 112 may face a first direction (z-axis direction), and the fourth surface 122 may face a second direction (-z-axis direction).

According to various embodiments, the first housing 110 may include a first side frame 113 that at least partially forms an external shape of the electronic device 301 and a first rear cover 114 combined with the first side frame 113 and that forms at least a part of the second surface 112 of the electronic device 301. According to an embodiment, the first side frame 113 may include a first side surface 113a, a second side surface 113b extended from one end of the first side surface 113a, and a third side surface 113c extended from the other end of the first side surface 113a. According to an embodiment, the first side frame 113 may be formed in a rectangular (e.g., square) shape through the first side surface 113a, the second side surface 113b, and the third side surface 113c.

According to various embodiments, the second housing 120 may include a second side frame 123 that at least partially forms an external shape of the electronic device 301 and a second rear cover 124 combined with the second side frame 123 and that forms at least a portion of the fourth surface 122 of the electronic device 301. According to an embodiment, the second side frame 123 may include a fourth side surface 123a, a fifth side surface 123b extended from one end of the fourth side surface 123a, and a sixth side surface 123c extended from the other end of the fourth side surface 123b. According to an embodiment, the second side frame 123 may be formed in a rectangular shape through the fourth side surface 123a, the fifth side surface 123b, and the sixth side surface 123c.

According to various embodiments, the pair of housings 110 and 120 are not limited to the illustrated shapes and couplings, and may be implemented by combinations and/or couplings of other shapes or components. For example, in some embodiments, the first side frame 113 may be integrally formed with the first rear cover 114, and the second side frame 123 may be integrally formed with the second rear cover 124.

According to various embodiments, in an unfolding state of the electronic device 301, the second side surface 113b of the first side frame 113 and the fifth side surface 123b of the second side frame 123 may be connected without a gap. According to an embodiment, in an unfolding state of the electronic device 301, the third side surface 113c of the first side frame 113 and the sixth side surface 123c of the second side frame 123 may be connected without a gap. According to an embodiment, in an unfolding state of the electronic device 301, an added length of the second side surface 113b and the fifth side surface 123b may be constituted to be longer than a length(s) of the first side surface 113a and/or the fourth side surface 123a. Further, an added length of the third side surface 113c and the sixth side surface 123c may be constituted to be longer than a length(s) of the first side surface 113a and/or the fourth side surface 123a.

According to various embodiments, the first side frame 113 and/or the second side frame 123 may be made of a metal or may further include a polymer injected into the metal. According to an embodiment, the first side frame 113 and/or the second side frame 123 may include at least one conductive portion 116 and/or 126 electrically segmented through at least one segment part 1161 and 1162 and/or 1261 and 1262 made of a polymer. In this case, at least one conductive portion may be electrically connected to a wireless communication circuit included in the electronic device 301 to be used as an antenna operating in at least one designated band (e.g., legacy band).

According to various embodiments, the first rear cover 114 and/or the second rear cover 124 may be formed by, for example, at least one or a combination of at least two of coated or tinted glass, ceramic, polymer, or metal (e.g., aluminum, stainless steel (STS)), or magnesium).

According to various embodiments, the flexible display 400 may be disposed to be extended from the first surface 111 of the first housing 110 to at least a portion of the third surface 121 of the second housing 120 across the hinge module. For example, the flexible display 400 may include a first flat portion 130a substantially corresponding to the first surface 111, a second flat portion 130b corresponding to the second surface 121, and a bendable portion 130c for connecting the first flat portion 130a and the second flat portion 130b and corresponding to the hinge module. According to an embodiment, the electronic device 301 may include a first protection cover 115 (e.g., first protection frame or first decorative member) coupled along an edge of the first housing 110. According to an embodiment, the electronic device 301 may include a second protection cover 125 (e.g., second protection frame or second decorative member) coupled along an edge of the second housing 120. According to an embodiment, the first protection cover 115 and/or the second protection cover 125 may be made of a metal or polymer material. According to an embodiment, the first protection cover 115 and/or the second protection cover 125 may be used as a decoration member. According to an embodiment, the flexible display 400 may be positioned such that an edge of the first flat portion 130a is interposed between the first housing 110 and the first protection cover 115. According to an embodiment, the flexible display 400 may be positioned such that an edge of the second flat portion 130b is interposed between the second housing 120 and the second protection cover 125. According to an embodiment, the flexible display 400 may be positioned so that an edge of the flexible display 400 corresponding to a protection cap is protected through the protection cap disposed in an area corresponding to the hinge module. Therefore, the edge of the flexible display 400 may be substantially protected from the outside. According to an embodiment, the electronic device 301 may include a hinge housing 141 (e.g., hinge cover) for supporting the hinge module, the hinge housing exposed to the outside when the electronic device 301 is in a folding state and disposed to be invisible from the outside by being introduced into the first space and the second space when the electronic device 301 is in an unfolding state.

According to various embodiments, the electronic device 301 may include a sub display 131 disposed separately from the flexible display 400. According to an embodiment, as the sub display 131 is disposed to be at least partially exposed at the second surface 112 of the first housing 110, the sub display 131 may display state information of the electronic device 301 that replaces a display function of the flexible display 400 when the electronic device 301 is in a folding state. According to an embodiment, the sub display 131 may be disposed to be visible from the outside through at least a partial area of the first rear cover 114. In some embodiments, the sub display 131 may be disposed at the fourth surface 124 of the second housing 120. In this case, the sub display 131 may be disposed to be visible from the outside through at least a partial area of the second rear cover 124.

According to various embodiments, the electronic device 301 may include at least one of an input device 103 (e.g., microphone), sound output devices 101 and 102, a sensor module 104, camera devices 105 and 108, a key input device 106, or a connector port 107. In the illustrated embodiment, the input device 103 (e.g., microphone), sound output devices 101 and 102, sensor modules 104, camera devices 105 and 108, key input device 106, or connector port 107 refer to a hole or shape formed in the first housing 110 or the second housing 120, but may be defined to include a substantial electronic component (e.g., input device, sound output device, sensor module, or camera device) disposed inside the electronic device 301 and operating through the hole or shape.

According to various embodiments, the input device 103 may include at least one microphone 103 disposed in the second housing 120. In some embodiments, the input device 103 may include a plurality of microphones 103 disposed to detect a direction of a sound. In some embodiments, the plurality of microphones 103 may be disposed at appropriate locations in the first housing 110 and/or the second housing 120. According to an embodiment, the sound output devices 101 and 102 may include speakers 101 and 102. According to an embodiment, the speakers 101 and 102 may include a call receiver 101 disposed in the first housing 110 and a speaker 102 disposed in the second housing 120. In some embodiments, the input device 103, sound output devices 101 and 102, and connector port 107 may be disposed in a space provided in the first housing 110 and/or the second housing 120 of the electronic device 301 and be exposed to an external environment through at least one hole formed in the first housing 110 and/or the second housing 120. According to an embodiment, at least one connector port 107 may be used for transmitting and receiving power and/or data to and from an external electronic device. In some embodiments, at least one connector port (e.g., ear jack hole) may receive a connector (e.g., ear jack) for transmitting and receiving an audio signal to and from an external electronic device. In some embodiments, holes formed in the first housing 110 and/or the second housing 120 may be commonly used for the input device 103 and the sound output devices 101 and 102. In some embodiments, the sound output devices 101 and 102 may include a speaker (e.g., piezo speaker) for operating while excluding holes formed in the first housing 110 and/or the second housing 120.

According to various embodiments, the sensor module 104 may generate an electrical signal or data value corresponding to an internal operating state of the electronic device 301 or an external environmental state. The sensor module 104 may detect, for example, an external environment through the first surface 111 of the first housing 110. In some embodiments, the electronic device 301 may further include at least one sensor module disposed to detect an external environment through the second surface 112 of the first housing 110. According to an embodiment, the sensor module 104 (e.g., illuminance sensor) may be disposed under the flexible display 400 so as to detect an external environment through the flexible display 400. According to an embodiment, the sensor module 104 may include at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, an illuminance sensor, a proximity sensor, an ultrasonic sensor, or an illuminance sensor 104.

According to various embodiments, the camera devices 105 and 108 may include a first camera device 105 (e.g., front camera device) disposed at the first surface 111 of the first housing 110 and a second camera device 108 disposed at the second surface 112 of the first housing 110. The electronic device 301 may further include a flash 109 disposed near the second camera device 108. According to an embodiment, the camera devices 105 and 108 may include one or a plurality of lenses, an image sensor, and/or an image signal processor. The flash 109 may include, for example, a light emitting diode or a xenon lamp. According to an embodiment, the camera devices 105 and 108 may be disposed so that two or more lenses (wide-angle lens, ultra-wide-angle lens, or telephoto lens) and image sensors are positioned at one surface (e.g., the first surface 111, the second surface 112, the third surface 121, or the fourth surface 122) of the electronic device 301. In some embodiments, the camera devices 105 and 108 may include image sensors and lenses for time of flight (TOF).

According to various embodiments, the key input device 106 (e.g., key button) may be disposed at the third side surface 113c of the first side frame 113 of the first housing 110. In some embodiments, the key input device 106 may be disposed in at least one side surface of other side surfaces 113a and 113b of the first housing 110 and/or side surfaces 123a, 123b, and 123c of the second housing 120. In some embodiments, the electronic device 301 may not include some or all of the key input devices 106, and key input devices 106 that are not included may be implemented in other forms such as soft keys on the flexible display 400. In some embodiments, the key input device 106 may be implemented using a pressure sensor included in the flexible display 400.

According to various embodiments, some camera devices 105 or sensor modules 104 among the camera devices 105 and 108 may be disposed to be exposed through the flexible display 400. For example, the first camera device 105 or the sensor module 104 may be disposed to come into contact with the external environment through an opening (e.g., through hole) formed at least partially in the flexible display 400 in an internal space of the electronic device 301. In another embodiment, some sensor modules 104 may be disposed to perform a function thereof without being visually exposed through the flexible display 400 in the internal space of the electronic device 301. For example, in this case, an area of the flexible display 400 facing the sensor module may not require an opening.

With reference to FIG. 2B, the electronic device 301 may be operated to maintain an intermediate state through a hinge module. In this case, the electronic device 301 may control the flexible display 400 so that different contents are displayed in a display area corresponding to the first surface 111 and a display area corresponding to the third surface 121. According to an embodiment, the electronic device 301 may operate in a substantially unfolding state (e.g., the unfolding state of FIG. 1A) and/or a substantially folding state (e.g., the folding state of FIG. 2A) based on a predetermined inflection angle (e.g., an angle between the first housing 110 and the second housing 120 in an intermediate state) through the hinge module. For example, in the case that a pressing force is provided in the unfolding direction (direction B) through the hinge module in an unfolding state at a predetermined inflection angle, the electronic device 301 may be operated to vary in an unfolding state (e.g., an unfolding state of FIG. 1A). For example, in the case that a pressing force is provided in a direction (direction C) to be folded in a state in which the electronic device 301 is unfolded at a predetermined inflection angle through the hinge module, the electronic device 301 may be operated to vary in a closed state (e.g., the folding state of FIG. 2A). In an embodiment, the electronic device 301 may be operated to maintain an unfolding state (not illustrated) at various angles through the hinge module.

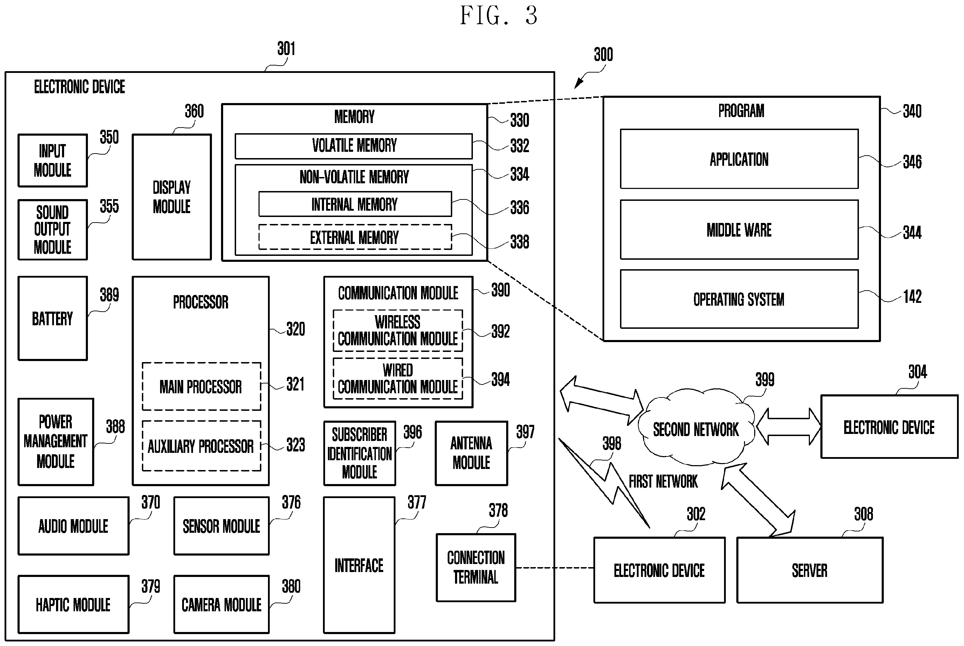

Fig. 3 is a block diagram illustrating an electronic device 301 in a network environment 300 according to various embodiments.

Referring to Fig. 3, the electronic device 301 in the network environment 300 may communicate with an electronic device 302 via a first network 398 (e.g., a short-range wireless communication network), or at least one of an electronic device 304 or a server 308 via a second network 399 (e.g., a long-range wireless communication network). According to an embodiment, the electronic device 301 may communicate with the electronic device 304 via the server 308. According to an embodiment, the electronic device 301 may include a processor 320, memory 330, an input module 350, a sound output module 355, a display module 360, an audio module 370, a sensor module 376, an interface 377, a connecting terminal 378, a haptic module 379, a camera module 380, a power management module 388, a battery 389, a communication module 390, a subscriber identification module(SIM) 396, or an antenna module 397. In some embodiments, at least one of the components (e.g., the connecting terminal 378) may be omitted from the electronic device 301, or one or more other components may be added in the electronic device 301. In some embodiments, some of the components (e.g., the sensor module 376, the camera module 380, or the antenna module 397) may be implemented as a single component (e.g., the display module 360).

The processor 320 may execute, for example, software (e.g., a program 340) to control at least one other component (e.g., a hardware or software component) of the electronic device 301 coupled with the processor 320, and may perform various data processing or computation. According to one embodiment, as at least part of the data processing or computation, the processor 320 may store a command or data received from another component (e.g., the sensor module 376 or the communication module 390) in volatile memory 332, process the command or the data stored in the volatile memory 332, and store resulting data in non-volatile memory 334. According to an embodiment, the processor 320 may include a main processor 321 (e.g., a central processing unit (CPU) or an application processor (AP)), or an auxiliary processor 323 (e.g., a graphics processing unit (GPU), a neural processing unit (NPU), an image signal processor (ISP), a sensor hub processor, or a communication processor (CP)) that is operable independently from, or in conjunction with, the main processor 321. For example, when the electronic device 301 includes the main processor 321 and the auxiliary processor 323, the auxiliary processor 323 may be adapted to consume less power than the main processor 321, or to be specific to a specified function. The auxiliary processor 323 may be implemented as separate from, or as part of the main processor 321.

The auxiliary processor 323 may control at least some of functions or states related to at least one component (e.g., the display module 360, the sensor module 376, or the communication module 390) among the components of the electronic device 301, instead of the main processor 321 while the main processor 321 is in an inactive (e.g., sleep) state, or together with the main processor 321 while the main processor 321 is in an active state (e.g., executing an application). According to an embodiment, the auxiliary processor 323 (e.g., an image signal processor or a communication processor) may be implemented as part of another component (e.g., the camera module 380 or the communication module 390) functionally related to the auxiliary processor 323. According to an embodiment, the auxiliary processor 323 (e.g., the neural processing unit) may include a hardware structure specified for artificial intelligence model processing. An artificial intelligence model may be generated by machine learning. Such learning may be performed, e.g., by the electronic device 301 where the artificial intelligence is performed or via a separate server (e.g., the server 308). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 330 may store various data used by at least one component (e.g., the processor 320 or the sensor module 376) of the electronic device 301. The various data may include, for example, software (e.g., the program 340) and input data or output data for a command related thererto. The memory 330 may include the volatile memory 332 or the non-volatile memory 334.

The program 340 may be stored in the memory 330 as software, and may include, for example, an operating system (OS) 342, middleware 344, or an application 346.

The input module 350 may receive a command or data to be used by another component (e.g., the processor 320) of the electronic device 301, from the outside (e.g., a user) of the electronic device 301. The input module 350 may include, for example, a microphone, a mouse, a keyboard, a key (e.g., a button), or a digital pen (e.g., a stylus pen).

The sound output module 355 may output sound signals to the outside of the electronic device 301. The sound output module 355 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 360 may visually provide information to the outside (e.g., a user) of the electronic device 301. The display module 360 may include, for example, a display, a hologram device, or a projector and control circuitry to control a corresponding one of the display, hologram device, and projector. According to an embodiment, the display module 360 may include a touch sensor adapted to detect a touch, or a pressure sensor adapted to measure the intensity of force incurred by the touch.

The audio module 370 may convert a sound into an electrical signal and vice versa. According to an embodiment, the audio module 370 may obtain the sound via the input module 350, or output the sound via the sound output module 355 or a headphone of an external electronic device (e.g., an electronic device 302) directly (e.g., wiredly) or wirelessly coupled with the electronic device 301.

The sensor module 376 may detect an operational state (e.g., power or temperature) of the electronic device 301 or an environmental state (e.g., a state of a user) external to the electronic device 301, and then generate an electrical signal or data value corresponding to the detected state. According to an embodiment, the sensor module 376 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 377 may support one or more specified protocols to be used for the electronic device 301 to be coupled with the external electronic device (e.g., the electronic device 302) directly (e.g., wiredly) or wirelessly. According to an embodiment, the interface 377 may include, for example, a high definition multimedia interface (HDMI), a universal serial bus (USB) interface, a secure digital (SD) card interface, or an audio interface.

A connecting terminal 378 may include a connector via which the electronic device 301 may be physically connected with the external electronic device (e.g., the electronic device 302). According to an embodiment, the connecting terminal 378 may include, for example, a HDMI connector, a USB connector, a SD card connector, or an audio connector (e.g., a headphone connector).

The haptic module 379 may convert an electrical signal into a mechanical stimulus (e.g., a vibration or a movement) or electrical stimulus which may be recognized by a user via his tactile sensation or kinesthetic sensation. According to an embodiment, the haptic module 379 may include, for example, a motor, a piezoelectric element, or an electric stimulator.

The camera module 380 may capture a still image or moving images. According to an embodiment, the camera module 380 may include one or more lenses, image sensors, image signal processors, or flashes.

The power management module 388 may manage power supplied to the electronic device 301. According to one embodiment, the power management module 388 may be implemented as at least part of, for example, a power management integrated circuit (PMIC).

The battery 389 may supply power to at least one component of the electronic device 301. According to an embodiment, the battery 389 may include, for example, a primary cell which is not rechargeable, a secondary cell which is rechargeable, or a fuel cell.

The communication module 390 may support establishing a direct (e.g., wired) communication channel or a wireless communication channel between the electronic device 301 and the external electronic device (e.g., the electronic device 302, the electronic device 304, or the server 308) and performing communication via the established communication channel. The communication module 390 may include one or more communication processors that are operable independently from the processor 320 (e.g., the application processor (AP)) and supports a direct (e.g., wired) communication or a wireless communication. According to an embodiment, the communication module 390 may include a wireless communication module 392 (e.g., a cellular communication module, a short-range wireless communication module, or a global navigation satellite system (GNSS) communication module) or a wired communication module 394 (e.g., a local area network (LAN) communication module or a power line communication (PLC) module). A corresponding one of these communication modules may communicate with the external electronic device via the first network 398 (e.g., a short-range communication network, such as Bluetooth^{™}, wireless-fidelity (Wi-Fi) direct, or infrared data association (IrDA)) or the second network 399 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 392 may identify and authenticate the electronic device 301 in a communication network, such as the first network 398 or the second network 399, using subscriber information (e.g., international mobile subscriber identity (IMSI)) stored in the subscriber identification module 396.

The wireless communication module 392 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 392 may support a high-frequency band (e.g., the mmWave band) to achieve, e.g., a high data transmission rate. The wireless communication module 392 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 392 may support various requirements specified in the electronic device 301, an external electronic device (e.g., the electronic device 304), or a network system (e.g., the second network 399). According to an embodiment, the wireless communication module 392 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 397 may transmit or receive a signal or power to or from the outside (e.g., the external electronic device) of the electronic device 301. According to an embodiment, the antenna module 397 may include an antenna including a radiating element composed of a conductive material or a conductive pattern formed in or on a substrate (e.g., a printed circuit board (PCB)). According to an embodiment, the antenna module 397 may include a plurality of antennas (e.g., array antennas). In such a case, at least one antenna appropriate for a communication scheme used in the communication network, such as the first network 398 or the second network 399, may be selected, for example, by the communication module 390 (e.g., the wireless communication module 392) from the plurality of antennas. The signal or the power may then be transmitted or received between the communication module 390 and the external electronic device via the selected at least one antenna. According to an embodiment, another component (e.g., a radio frequency integrated circuit (RFIC)) other than the radiating element may be additionally formed as part of the antenna module 397.

According to various embodiments, the antenna module 397 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 301 and the external electronic device 304 via the server 308 coupled with the second network 399. Each of the electronic devices 302 or 304 may be a device of a same type as, or a different type, from the electronic device 301. According to an embodiment, all or some of operations to be executed at the electronic device 301 may be executed at one or more of the external electronic devices 302, 304, or 308. For example, if the electronic device 301 should perform a function or a service automatically, or in response to a request from a user or another device, the electronic device 301, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 301. The electronic device 301 may provide the outcome, with or without further processing of the outcome, as at least part of a reply to the request. To that end, a cloud computing, distributed computing, mobile edge computing (MEC), or client-server computing technology may be used, for example. The electronic device 301 may provide ultra low-latency services using, e.g., distributed computing or mobile edge computing. In another embodiment, the external electronic device 304 may include an internet-of things (IoT) device. The server 308 may be an intelligent server using machine learning and/or a neural network. According to an embodiment, the external electronic device 304 or the server 308 may be included in the second network 399. The electronic device 301 may be applied to intelligent services (e.g., smart home, smart city, smart car, or healthcare) based on 5G communication technology or IoT-related technology.

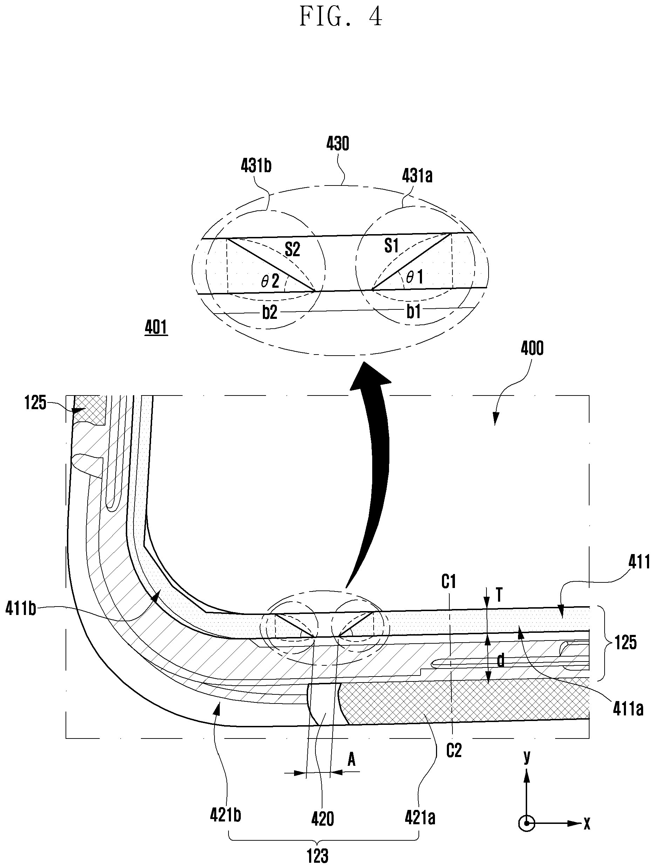

FIG. 4 is a diagram specifically illustrating an area 401 in FIG. 1A according to various embodiments.

With reference to FIG. 4, the electronic device 301 may include a second side frame 123, a second protection cover 125, a flexible display 400, and a conductive member 411.

The second side frame 123 may include a first metal frame 421a, a second metal frame 421b, and/or a segment part 420. The first metal frame 421a may correspond to a fourth side surface 123a, and the second metal frame 421b may correspond to a fifth side surface 123b. The first metal frame 421a and/or the second metal frame 421b may operate as an antenna formed as a part of the antenna module 397.

A length of the first metal frame 421a and/or the second metal frame 421b may have a length corresponding to a frequency band for wireless communication of the electronic device 301. For example, the length of the first metal frame 421a and/or the second metal frame 421b may have a length corresponding to a resonant frequency or a natural frequency for wireless communication of the electronic device 301.

The segment part 420 may be an insulator and/or a dielectric disposed between the first metal frame 421a and/or the second metal frame 421b.

The segment part 420 may include a predetermined length A in the x-axis direction. The segment part 420 may space the first metal frame 421a and/or the second metal frame 421b apart by a predetermined length A.

The second protection cover 125 may be made of a metal and/or polymer material. The second protection cover 125 may be used as a decoration member.

The second protection cover 125 may cover at least a portion of the flexible display 400. The second protection cover 125 may be spaced apart from the flexible display 400 by a predetermined interval. At least a part of the second protection cover 125 may be connected to the second side frame 123. The second protection cover 125 may be extended from the second side frame 123 toward the flexible display 400 to cover at least a portion of the flexible display 400.

The electronic device 301 may dispose the flexible display 400 at the first surface 111 facing the first direction (e.g., front direction) (z-axis direction). The flexible display 400 may be the same as or similar to the display module 160 of FIG. 3.

With reference to FIGS. 1B and 4, the flexible display 400 may be positioned such that an edge of the second flat portion 130b is interposed between the second housing 120 and the second protection cover 125.

The conductive member 411 may be deposited or plated on at least a portion of the second protection cover 125. In various embodiments, the conductive member 411 may be bonded to at least a portion of the second protection cover 125 with a conductive tape.

The conductive member 411 may be disposed in at least a part of the lower portion of the second protection cover 125.

The conductive member 411 may be spaced apart from the second side frame 123 by a predetermined distance d to be disposed in at least a portion of the second protection cover 125.

The conductive member 411 may include a first conductive area 411a, a second conductive area 411b, and a segment area 430.

The first conductive area 411a may be spaced apart from the second conductive area 411b by a predetermined length A. An area in which the first conductive area 411a and the second conductive area 411b are separated may correspond to the segment part 420.

The segment area 430 may include a first sharp end (or spire) 431a and/or a second sharp end 431b. The first sharp end 431a may be at least a portion of the first conductive area 411a. The second sharp end 431b may be at least a portion of the second conductive area 411b.

The first sharp end 431a and the second sharp end 431b may be spaced apart by a predetermined length A. The conductive member 411 may move electrons or electric charges through the first sharp end 431a and the second sharp end 431b. For example, static electricity may be introduced into the electronic device 301. The conductive member 411 may transfer static electricity introduced to the electronic device 301 to the first conductive area 411a and/or the second conductive area 411b through the first sharp end 431a and/or the second sharp end 431b. For example, the first sharp end 431a may transfer electrons, electric charges, or static electricity from the first conductive area 411a to the second conductive area 411b through the second sharp end 431b. The second sharp end 431b may transfer electrons, electric charges, or static electricity from the second conductive area 411b to the first conductive area 411a through the first sharp end 431a. Static electricity transferred to the first conductive area 411a and/or the second conductive area 411b through the first sharp end 431a and/or the second sharp end 431b may be transferred to a ground of the electronic device 301. At least a portion of the conductive member 411 may be electrically connected to the ground of the electronic device 301. The ground of the electronic device 301 may be, for example, a ground of a printed circuit board included in the electronic device 301.

The first conductive area 411a, the second conductive area 411b, and the conductive member 411 may be deposited and/or plated on at least a portion of the second protection cover 125 while having a predetermined width T. The first conductive area 411a, the second conductive area 411b, and the conductive member 411 may be conductive tapes having a predetermined width T.

In various embodiments, in the first conductive area 411a, a length of the first metal frame 421a side may be different from that of the flexible display 400 side in the first sharp end 431a or an area adjacent to the first sharp end 431a.

In various embodiments, in the first conductive area 411a, a length of the first metal frame 421a side may be longer than that of the flexible display 400 side in the first sharp end 431a or an area adjacent to the first sharp end 431a. In the first conductive area 411a, the length of the first metal frame 421a side may be longer than that of the flexible display 400 side by a first protrusion line b1.

In various embodiments, in the first conductive area 411a, when the length of the first metal frame 421a side is longer than that of the flexible display 400 side and there is thus a step, the first sharp end 431a may have a shape connecting the step with a slope.

In various embodiments, the first sharp end 431a may include a line of the first metal frame 421a side, a line of the flexible display 400 side, and a first slope line S1.

In various embodiments, the first slope line S1 may be a line meeting the line of the flexible display 400 side at a second angle Θ2 with the line of the first metal frame 421a side. The length of the first slope line S1 may be defined by, for example, a predetermined width T and the length of the first protrusion line b1.

In various embodiments, the first sharp end 431a may be an area obtained by diagonally cutting the first conductive area 411a.

In various embodiments, the first sharp end 431a may be an area where the first slope line S 1 and the first protrusion line b1 meeting at one point are widened by a predetermined width T while forming a first angle θ1.

In various embodiments, it may be characterized that the first sharp end 431a has a predetermined width T in a partial area of the first conductive area 411a and gradually decreases while forming a first angle θ1 so that a width thereof becomes 0.

In the second conductive area 411b, the length of the second metal frame 421b side may be different from that of the flexible display 400 side in the second sharp end 43 1b or an area adjacent to the second sharp end 431b.

In various embodiments, in the second conductive area 411b, the length of the first metal frame 421a side may be longer than that of the flexible display 400 side in the second sharp end 431b or an area adjacent to the second sharp end 431b. In the second conductive area 411b, the length of the second metal frame 421b side may be longer than that of the flexible display 400 side by a second protrusion line b2.

In various embodiments, in the second conductive area 411b, when the length of the second metal frame 421b side is longer than that of the flexible display 400 side and there is thus a step, the second sharp end 431b may have a shape connecting the step with a slope.

In various embodiments, the second sharp end 43 1b may include a line of the second metal frame 421b side, a line of the flexible display 400 side, and a second slope line S2.

In various embodiments, the second slope line S2 may be a line meeting a line of the flexible display 400 side at a second angle Θ2 with a line of the second metal frame 421b side. The length of the second slope line S2 may be defined by, for example, a predetermined width T and the length of the second protrusion line b2.

In various embodiments, the second sharp end 431b may be an area obtained by diagonally cutting the second conductive area 411b.

In various embodiments, the second sharp end 431b may be an area where the second slope line S2 and the second protrusion line b2 meeting at one point are widened by a predetermined width T while forming a second angle Θ2.

In various embodiments, it may be characterized that the second sharp end 431b has a predetermined width T in a partial area of the second conductive area 411b and gradually decreases while forming a second angle Θ2 so that a width thereof becomes 0.

In various embodiments, the first angle θ1 and the second angle Θ2 may be the same or different. A length of the first slope line S1 and a length of the second slope line S2 may be the same as or different from each other. A length of the first protrusion line b1 and a length of the second protrusion line b2 may be the same as or different from each other.

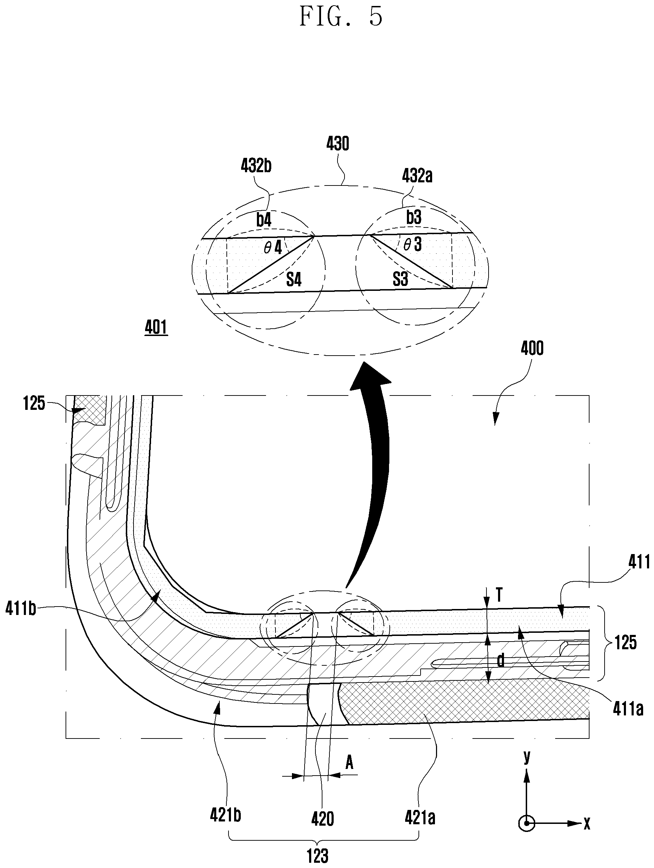

FIG. 5 is a diagram specifically illustrating an area 401 in FIG. 1A according to various embodiments.

FIG. 5 may have a different segment area 430 from FIG. 4, and the remaining portions of FIG. 5 may be the same as those of FIG. 4. When FIG. 5 is described centering on the segment area 430 while omitting the same area as that of FIG. 4, the conductive member 411 may include a first conductive area 411a, a second conductive area 411b, and a segment area 430.

The first conductive area 411a may be spaced apart from the second conductive area 411b by a predetermined length A. An area in which the first conductive area 411a and the second conductive area 411b are separated may correspond to the segment part 420.

The segment area 430 may include a third sharp end 432a and/or a fourth sharp end 432b. The third sharp end 432a may be at least a portion of the first conductive area 411a. The fourth sharp end 432b may be at least a portion of the second conductive area 411b.

The third sharp end 432a and the fourth sharp end 432b may be spaced apart by a predetermined length A. The conductive member 411 may move electrons or electric charges through the third sharp end 432a and the fourth sharp end 432b. For example, static electricity may be introduced into the electronic device 301. The conductive member 411 may transfer static electricity introduced to the electronic device 301 to the first conductive area 411a and/or the second conductive area 411b through the third sharp end 432a and the fourth sharp end 432b. For example, the third sharp end 432a may transfer electrons, electric charges, or static electricity from the first conductive area 411a to the second conductive area 411b through the fourth sharp end 432b. The fourth sharp end 432b may transfer electrons, electric charges, or static electricity from the second conductive area 411b to the first conductive area 411a through the third sharp end 432a.

Static electricity transferred to the first conductive area 411a and/or the second conductive area 411b through the third sharp end 432a and/or the fourth sharp end 432b may be transferred to the ground of the electronic device 301. At least a portion of the conductive member 411 may be electrically connected to the ground of the electronic device 301. The ground of the electronic device 301 may be, for example, a ground of a printed circuit board included in the electronic device 301.

The first conductive area 411a, the second conductive area 411b, and the conductive member 411 may be deposited and/or plated on at least a portion of the second protection cover 125 while having a predetermined width T. The first conductive area 411a, the second conductive area 411b, and the conductive member 411 may be conductive tapes having a predetermined width T.

In various embodiments, in the first conductive area 411a, a length of the first metal frame 421a side may be different from that of the flexible display 400 side in the third sharp end 432a or an area adjacent to the fourth sharp end 432a.

In various embodiments, in the first conductive area 411a, the length of the flexible display 400 side may be longer than that of the first metal frame 421a side in the third sharp end 432a or an area adjacent to the fourth sharp end 432a. In the first conductive area 411a, the length of the flexible display 400 side may be longer than that of the first metal frame 421a side by a third protrusion line b3.

In various embodiments, in the first conductive area 411a, when the length of the flexible display 400 side is longer than that of the first metal frame 421a side and there is thus a step, the third sharp end 432a may have a shape connecting the step with a slope.

In various embodiments, the third sharp end 432a may include a line of the first metal frame 421a side, a line of the flexible display 400 side, and a third slope line S3.

In various embodiments, the third slope line S3 may be a line meeting the line of the flexible display 400 side at a third angle Θ3 with the line of the first metal frame 421a side. A length of the third slope line S3 may be defined by, for example, a predetermined width T and a length of the third protrusion line b3.

In various embodiments, the third sharp end 432a may be an area obtained by diagonally cutting the first conductive area 411a.

In various embodiments, the third sharp end 432a may be an area where the third slope line S3 and the third protrusion line b3 meeting at one point are widened by a predetermined width T while forming a third angle Θ3.

In various embodiments, it may be characterized that the third sharp end 432a has a predetermined width T in a partial area of the first conductive area 411a and gradually decreases while forming a third angle Θ3 so that a width thereof becomes 0.

In the second conductive area 411b, a length of the second metal frame 421b side may be different from that of the flexible display 400 side in the fourth sharp end 432b or an area adjacent to the fourth sharp end 432b.

In various embodiments, in the second conductive area 411b, a length of the flexible display 400 side may be longer than that of the first metal frame 421a side in the fourth sharp end 432b or an area adjacent to the fourth sharp end 432b. In the second conductive area 411b, the length of the flexible display 400 side may be longer than that of the first metal frame 421a side by the fourth protrusion line b4.

In various embodiments, in the second conductive area 411b, when the length of the flexible display 400 side is longer than that of the second metal frame 421b side and there is thus a step, the fourth sharp end 432b may have a shape connecting the step with a slope.

In various embodiments, the fourth sharp end 432b may include a line of the second metal frame 421b side, a line of the flexible display 400 side, and a fourth slope line S4.

In various embodiments, the fourth slope line S4 may be a line meeting the line of the flexible display 400 side at a fourth angle Θ4 with the line of the second metal frame 421b side. The length of the fourth slope line S4 may be defined by, for example, a predetermined width T and the length of the fourth protrusion line b4.

In various embodiments, the fourth sharp end 432b may be an area obtained by diagonally cutting the second conductive area 411b.

In various embodiments, the fourth sharp end 432b may be an area where the fourth slope line S4 and the fourth protrusion line b4 meeting at one point are widened by a predetermined width T while forming a fourth angle Θ4.

In various embodiments, it may be characterized that the fourth sharp end 432b has a predetermined width T in a partial area of the second conductive area 411b and gradually decreases while forming a fourth angle Θ4 so that a width thereof becomes 0.

In various embodiments, the third angle Θ3 and the fourth angle Θ4 may be the same or different. A length of the third slope line S3 and a length of the fourth slope line S4 may be the same as or different from each other. A length of the third protrusion line b3 and a length of the fourth protrusion line b4 may be the same as or different from each other.

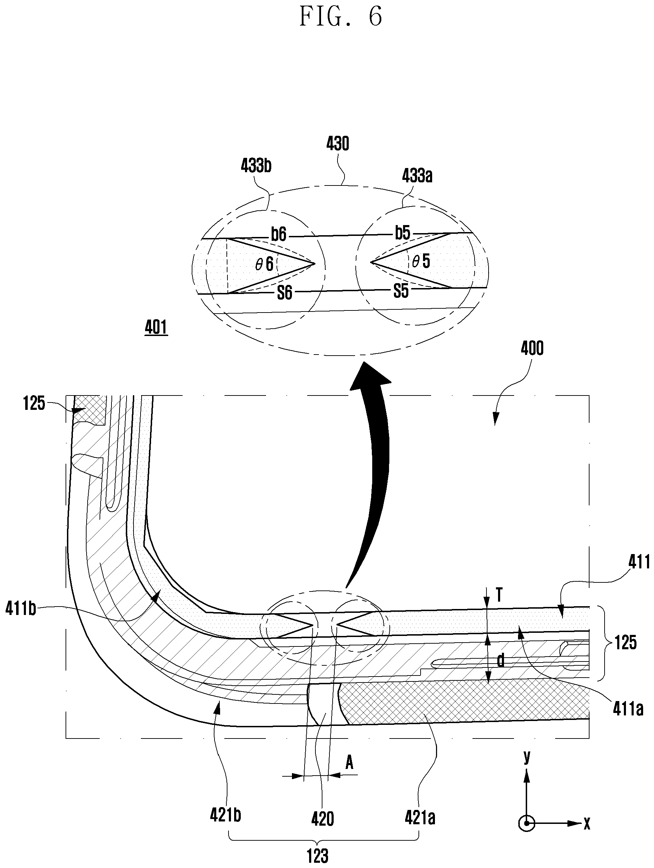

FIG. 6 is a diagram specifically illustrating an area 401 in FIG. 1A according to various embodiments.

FIG. 6 may have a different segment area 430 from FIG. 4, and the remaining portions of FIG. 6 may be the same as those of FIG. 4. When FIG. 6 is described centering on the segment area 430 while omitting the same area as that of FIG. 4, the conductive member 411 may include a first conductive area 411a, a second conductive area 411b, and a segment area 430.

The first conductive area 411a may be spaced apart from the second conductive area 411b by a predetermined length A. An area in which the first conductive area 411a and the second conductive area 411b are separated may correspond to the segment part 420.

The segment area 430 may include a fifth sharp end 433a and/or a sixth sharp end 433b. The fifth sharp end 433a may be at least a portion of the first conductive area 411a. The sixth sharp end 433b may be at least a portion of the second conductive area 411b.

The fifth sharp end 433a and the sixth sharp end 433b may be spaced apart by a predetermined length A. The conductive member 411 may move electrons or electric charges through the fifth sharp end 433a and the sixth sharp end 433b. For example, static electricity may be introduced into the electronic device 301. The conductive member 411 may transfer static electricity introduced to the electronic device 301 to the first conductive area 411a and/or the second conductive area 411b through the fifth sharp end 433a and the sixth sharp end 433b. For example, the fifth sharp end 433a may transfer electrons, electric charges, or static electricity from the first conductive area 411a to the second conductive area 411b through the sixth sharp end 433b. The sixth sharp end 433b may transfer electrons, electric charges, or static electricity from the second conductive area 411b to the first conductive area 411a through the fifth sharp end 433 a.

Static electricity transferred to the first conductive area 411a and/or the second conductive area 411b through the fifth sharp end 433a and/or the sixth sharp end 433b may be transferred to the ground of the electronic device 301. At least a portion of the conductive member 411 may be electrically connected to the ground of the electronic device 301. The ground of the electronic device 301 may be, for example, a ground of a printed circuit board included in the electronic device 301.

The first conductive area 411a, the second conductive area 411b, and the conductive member 411 may be deposited and/or plated on at least a portion of the second protection cover 125 while having a predetermined width T. The first conductive area 411a, the second conductive area 411b, and the conductive member 411 may be conductive tapes having a predetermined width T.

In various embodiments, the fifth sharp end 433a may be an area where a fifth slope line S5 and a fifth protrusion line b5 meeting at one point are widened by a predetermined width T while forming a fifth angle θ5.

In various embodiments, it may be characterized that the fifth sharp end 433a has a predetermined width T in a partial area of the first conductive area 411a and gradually decreases while forming a fifth angle θ5 so that a width thereof becomes 0.

In various embodiments, the sixth sharp end 433b may be an area where a sixth slope line S6 and a sixth protrusion line b6 meeting at one point are widened by a predetermined width T while forming a sixth angle θ6.

In various embodiments, it may be characterized that the sixth sharp end 433b has a predetermined width T in a partial area of the second conductive area 411b and gradually decreases while forming the sixth angle θ6 so that a width thereof becomes 0.

In various embodiments, the fifth angle θ5 and the sixth angle θ6 may be the same. A length of the fifth slope line S5 and a length of the sixth slope line S6 may be the same as each other. A length of the fifth protrusion line b5 and a length of the sixth protrusion line b6 may be the same as each other.

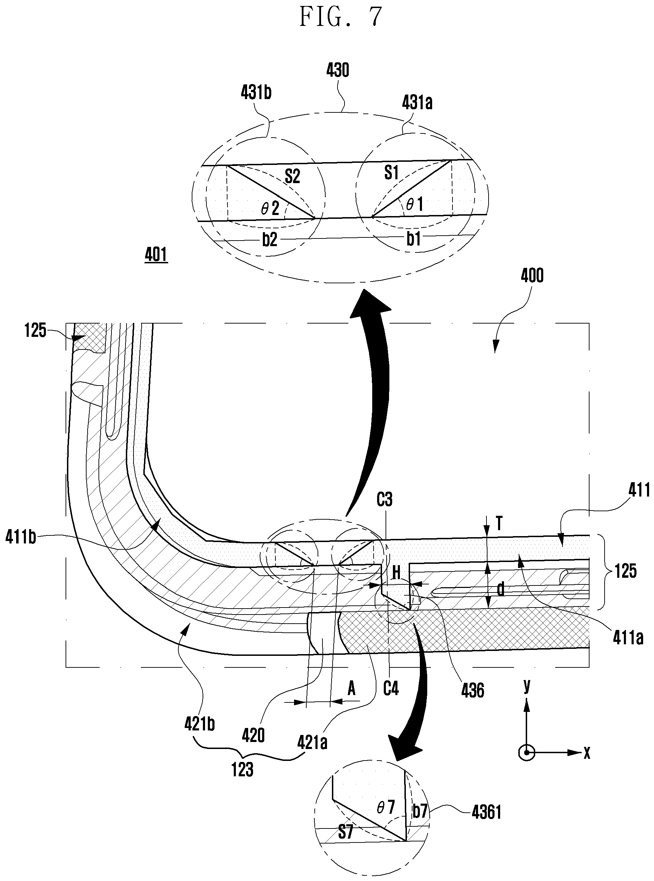

FIG. 7 is a diagram specifically illustrating an area 401 in FIG. 1A according to various embodiments.

FIG. 7 may have a different segment area 430 from that of FIG. 4, but the remaining portions of FIG. 7 may be the same as those of FIG. 4. When FIG. 7 is described centering on the segment area 430 while omitting the same area as that of FIG. 4, the conductive member 411 may include a first conductive area 411a, a second conductive area 411b, and a segment area 430.

The first conductive area 411a may be spaced apart from the second conductive area 411b by a predetermined length A. An area in which the first conductive area 411a and the second conductive area 411b are separated may correspond to the segment part 420.

The segment area 430 may include a first sharp end 431a and/or a second sharp end 431b. The first sharp end 431a may be at least a portion of the first conductive area 411a. The second sharp end 431b may be at least a portion of the second conductive area 411b.

The first sharp end 431a and/or the second sharp end 431b of FIG. 7 may be the same as the third sharp end 432a and/or the fourth sharp end 432b of FIG. 5.

In various embodiments, the first sharp end 431a and/or the second sharp end 431b of FIG. 7 may be the same as the fifth sharp end 433a and/or the sixth sharp end 433b of FIG. 6.

The segment area 430 of FIG. 7 may further include a bridge area 436 in the segment area 430 of FIGS. 4 to 6.

The bridge area 436 may be disposed in a direction of the second side frame 123 in at least one of the second conductive areas 411b.

In various embodiments, the bridge area 436 may be disposed in a direction of the second side frame 123 in at least one of the first conductive area 411a or the second conductive area 411b.

The bridge area 436 may be spaced apart from the first sharp end 43 1a to be disposed in at least one of the second conductive areas 411b in a direction of the second side frame 123.

In various embodiments, the bridge area 436 may be spaced apart from the second end portion 431b to be disposed in at least one of the second conductive areas 411b in the direction of the second side frame 123.

The bridge area 436 may have a predetermined width H. The predetermined width H of the bridge area 436 may be the same as or different from the predetermined width T of the conductive member 411.

The bridge area 436 may further include a seventh sharp end 4361. The seventh sharp end 4361 may be an area where a seventh slope line S7 and a seventh protrusion line b7 meeting at one point are widened by a predetermined width h while forming a seventh angle θ7.

In various embodiments, it may be characterized that the seventh sharp end 4361 has a predetermined width H in a partial area and gradually decreases while forming a seventh angle θ7 so that a width thereof becomes 0.

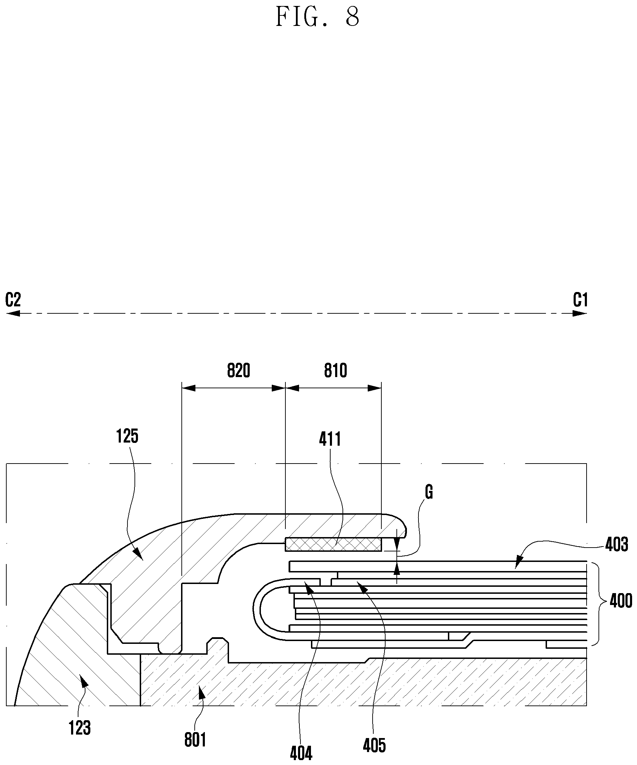

FIG. 8 is a diagram illustrating an area obtained by cutting the electronic device 301 of FIG. 4 in a C1-C2 direction.

The electronic device 301 may include a second side frame 123, a second protection cover 125, a flexible display 400, a conductive member 411, and a support plate 801.

At least a portion of the second side frame 123 may be coupled to the support plate 801.

The second protection cover 125 may cover at least a portion of the flexible display 400. The second protection cover 125 may be spaced apart from the flexible display 400 by a predetermined gap G.

At least a part of the second protection cover 125 may be connected to the second side frame 123. The second protection cover 125 may be extended from the second side frame 123 toward the flexible display 400 to cover at least a portion of the flexible display 400. The second protection cover 125 may include a first protection area 810 and a second protection area 820.

The flexible display 400 may include a polymer layer 403, a bending protect layer 404, and a polarizing plate 405.

The flexible display 400 may be disposed on the support plate 801.

The flexible display 400 may include an unbreakable (UB) type OLED display (e.g., curved display). However, the disclosure is not limited thereto, and the flexible display 400 may include an on cell touch active matrix organic light-emitting diode (AMOLED) flat type display (OCTA).

According to various embodiments, the display 400 may include a protection layer 403. The protection layer 403 may include polyethylene terephthalate (PET) or polyimide (PI) having excellent optical properties. The protection layer 403 may include thermoplastic polyurethane (TPU), which is relatively advantageous in terms of elasticity.

The flexible display 400 may include a polarizer (POL) 405 (e.g., polarization film) and a bending protect layer 404 sequentially disposed at a rear surface of a window layer. The window layer may include ultra-thin glass (UTG). In some embodiments, the window layer may include a polymer.

The bending protect layer 404 and the polarizing plate 405 may be spaced apart at predetermined intervals.

The flexible display 400 may include a control circuit. The control circuit may include a display driver IC (DDI) and/or a touch display driver IC (TDDI) disposed in a chip on panel (COP) or chip on film (COF) method.

The conductive member 411 may be disposed in at least a part of a lower portion of the second protection cover 125.

The conductive member 411 may be disposed in at least a part of the first protection area 810. The first protection area 810 may be spaced apart from the flexible display 400 by a predetermined gap G. The first protection area 810 may cover at least a portion of the flexible display 400.

In the first protection area 810, a conductive member 411, a first conductive area 411a, a second conductive area 411b, and a segment area 430 may be disposed.

The second protection area 820 may connect the first protection area 810 and the second protection cover 125.

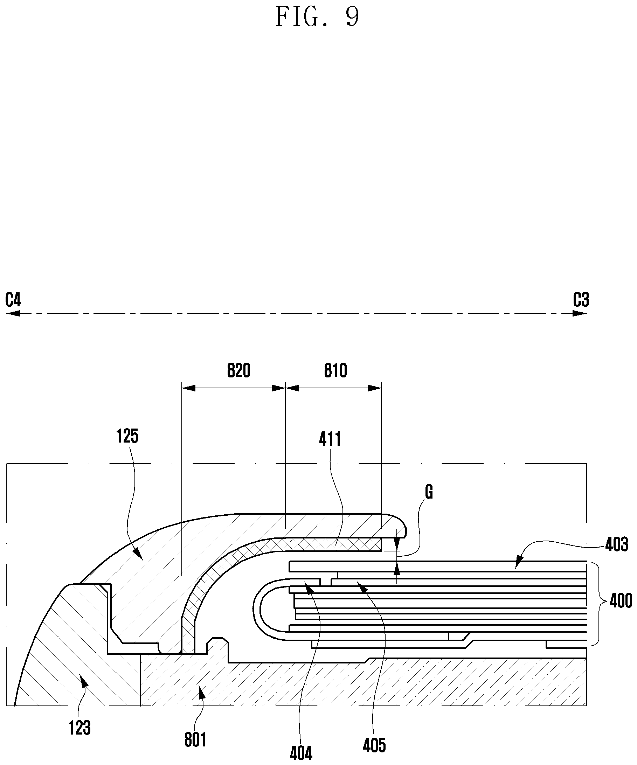

FIG. 9 is a diagram illustrating an area obtained by cutting the electronic device 301 of FIG. 7 in a C3-C4 direction.

In FIG. 9, some characteristics of the conductive member 411 may be different from those of FIG. 8, but the remaining portions of FIG. 9 may be the same as those of FIG. 8.

The conductive member 411 may be disposed in at least a part of a lower portion of the second protection cover 125.

The conductive member 411 may be disposed in at least a part of the first protection area 810. The first protection area 810 may be spaced apart from the flexible display 400 by a predetermined gap G. The first protection area 810 may cover at least a portion of the flexible display 400.

In the first protection area 810, a conductive member 411, a first conductive area 411a, a second conductive area 411b, and a segment area 430 may be disposed.

The second protection area 820 may connect the first protection area 810 and the second protection cover 125. A bridge area 436 may be disposed in the second protection area 820.

A conductive member 411 may be disposed in the first protection area 810 and the second protection area 820.

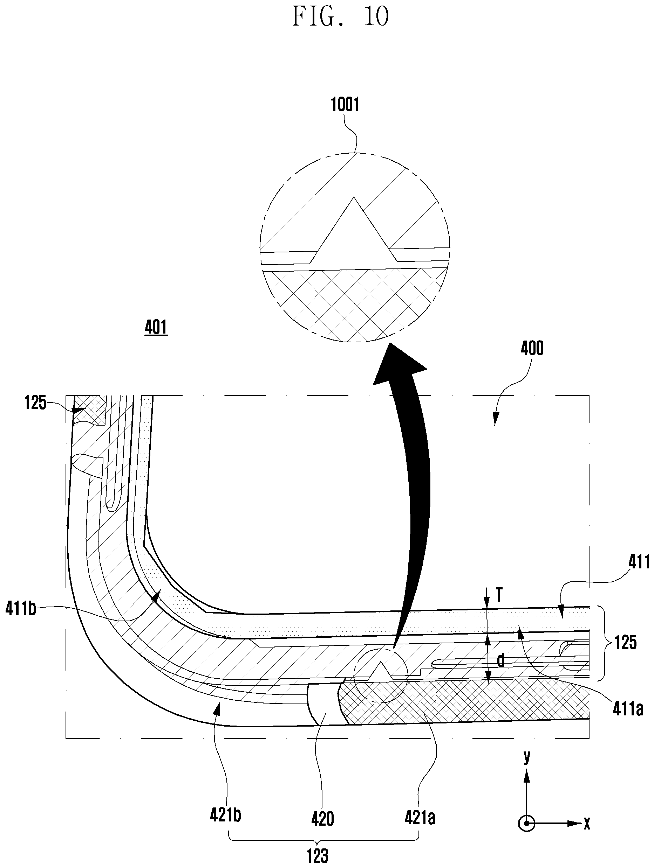

FIG. 10 is a diagram illustrating a second side frame 123 according to various embodiments of the disclosure.

The electronic device 301 may include a second side frame 123, a second protection cover 125, a flexible display 400, and a conductive member 411.

The second side frame 123 may include a first metal frame 421a, a second metal frame 421b, and/or a segment part 420.

The second side frame 123 may include a sharp end area 1001 in at least a part thereof.

The sharp end area 1001 has a triangular or pointed shape and may be disposed from the second side frame 123 toward the flexible display 400.

The sharp end area 1001 may be disposed at the first metal frame 421a and/or the second metal frame 421b of the second side frame 123.

In various embodiments, with reference to FIG. 7, the sharp end area 1001 may correspond to a seventh sharp end 4361 of the bridge area 436.

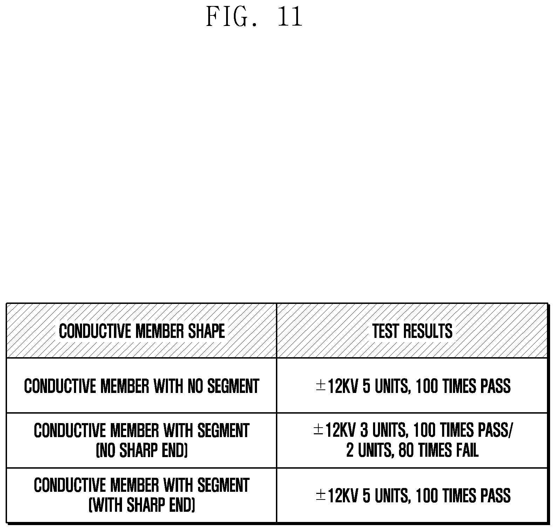

FIG. 11 is a table illustrating electro static discharge (ESD) test results according to various embodiments of the disclosure.

With reference to FIG. 11, comparing an electronic device 301 having a segment of a conductive member and a sharp end according to an embodiment of the disclosure and an electronic device having a segment of a conductive member and not having a sharp end of the prior art, when 2 out of 5 electronic devices having a segment of a conductive member and not having a sharp end of the prior art perform the test 80 times at ±12KV, the ESD test has failed, whereas when 5 electronic devices 301 having a segment of a conductive member and having a sharp end according to an embodiment of the disclosure have successfully performed the test 100 times at ±12KV, it may be identified that the ESD performance is improved.

The sharp end may be a first sharp end 431a and/or a second sharp end 43 1b according to various embodiments of the disclosure. The sharp end may be a third sharp end 432a and/or a fourth sharp end 432b according to various embodiments of the disclosure. The sharp end may be a fifth sharp end 433a and/or a sixth sharp end 433b according to various embodiments of the disclosure. The sharp end may be a seventh sharp end 4361 according to various embodiments of the disclosure.

A performance of the antenna of the electronic device 301 including the conductive member according to various embodiments of the disclosure may be equivalent to that of the conventional electronic device including the conductive member.

An electronic device according to various embodiments disclosed in this document may be various types of devices. The electronic device may include, for example, a portable communication device (e.g., smart phone), a computer device, a portable multimedia device, a portable medical device, a camera, a wearable device, or a home appliance device. The electronic device according to the embodiment of this document is not limited to the above-described devices.

It should be understood that various embodiments of this document and terms used therein are not intended to limit the technical features described in this document to specific embodiments, but include various modifications, equivalents, or substitutions of the embodiments. In connection with the description of the drawings, like reference numerals may be used for similar or related components. The singular form of the noun corresponding to the item may include one or more of the item, unless the relevant context clearly dictates otherwise. In this document, each of phrases such as "A or B", "at least one of A and B", "at least one of A or B", "A, B, or C", "at least one of A, B and C", and "at least one of A, B, or C" may include any one of, or all possible combinations of, items listed together in the corresponding one of the phrases. Terms such as "first" or "second" may be simply used for distinguishing a corresponding component from other corresponding components, and do not limit the corresponding components in other aspects (e.g., importance or order). In the case that one (e.g., first) component is referred to as "coupled" or "connected" to another (e.g., second) component, with or without the terms "functionally" or "communicatively, it means that the one component may be connected to the other component directly (e.g., by wire), wirelessly, or through a third component.

The term "module" used in various embodiments of this document may include a unit implemented in hardware, software, or firmware, and may be used interchangeably with terms such as, for example, logic, logic block, part, or circuit. A module may be an integrally formed part or a minimum unit or a portion of the part that performs one or more functions. For example, according to an embodiment, the module may be implemented in the form of an application-specific integrated circuit (ASIC).

Various embodiments of this document may be implemented into software (e.g., the program 140) including one or more instructions stored in a storage medium (e.g., the internal memory 136 or the external memory 138) readable by a machine (e.g., the electronic device 301). For example, the processor (e.g., the processor 120) of the device (e.g., the electronic device 301) may call and execute at least one command among one or more stored instructions from a storage medium. This makes it possible for the device to be operated to perform at least one function according to the called at least one instruction. The one or more instructions may include a code generated by a compiler or a code executable by an interpreter. The device-readable storage medium may be provided in the form of a non-transitory storage medium. Here, 'non-transitory' only means that the storage medium is a tangible device and does not include a signal (e.g., electromagnetic wave), and this term does not distinguish the case that data is semi-permanently stored in the storage medium and the case that data is temporary stored.

According to an embodiment, a method according to various embodiments disclosed in this document may be provided as included in a computer program product. Computer program products may be traded between sellers and buyers as commodities. The computer program product may be distributed in the form of a machine-readable storage medium (e.g., compact disc read only memory (CD-ROM)), or via an application store (e.g., Play Store^{™}) or may be distributed (e.g., download or upload) online directly between two user devices (e.g., smartphones). In the case of online distribution, at least a part of the computer program product may be at least temporarily stored or temporarily generated in a machine-readable storage medium such as a memory of a server of a manufacturer, a server of an application store, or a relay server.

According to various embodiments, each component (e.g., module or program) of the above-described components may include a singular or a plurality of entities, and some of the plurality of entities may be separately disposed in other components. According to various embodiments, one or more components or operations among the above-described corresponding components may be omitted, or one or more other components or operations may be added. Alternatively or additionally, a plurality of components (e.g., module or program) may be integrated into one component. In this case, the integrated component may perform one or more functions of each component of the plurality of components identically or similarly to those performed by the corresponding component among the plurality of components prior to the integration. According to various embodiments, operations performed by a module, program, or other component may be executed sequentially, in parallel, repeatedly, or heuristically, or one or more of the operations may be executed in a different order, or omitted, or one or more other operations may be added.

## Claims

1. An electronic device including a conductive member, the electronic device comprising:
a side frame configured to enclose a space between a first surface and a second surface parallel to the first surface;
a first metal frame and second metal frame disposed at the side frame;
a segment part disposed between the first metal frame and the second metal frame;
a flexible display disposed on the first surface;
a protection cover disposed in a direction extended from the side surface toward the first surface and configured to cover at least a portion of the flexible display; and
a conductive member disposed at a surface at which the protection cover faces the flexible display,
wherein the conductive member comprises a first sharp end and second sharp end segmented in an area corresponding to the segment part and capable of transferring electric charges.

2. The electronic device of claim 1, wherein the protection cover is spaced apart from the flexible display by a predetermined gap and is spaced apart from the first metal frame or the second metal frame by a predetermined distance.

3. The electronic device of claim 1, wherein the conductive member is configured to have a predetermined width.

4. The electronic device of claim 3, wherein in the conductive member having the predetermined width,
when a length of the side frame side is longer than that of the flexible display side and there is thus a step, the first sharp end is configured to have a shape connecting the step with a slope.

5. The electronic device of claim 3, wherein in the conductive member having the predetermined width,
when a length of the side frame side is longer than that of the flexible display side and there is thus a step, the second sharp end is configured to have a shape connecting the step with a slope.

6. The electronic device of claim 3, wherein in the conductive member having the predetermined width,
when a length of the flexible display side is longer than that of the side frame side and there is thus a step, the first sharp end is configured to have a shape connecting the step with a slope.

7. The electronic device of claim 3, wherein in the conductive member having the predetermined width,
when a length of the flexible display side is longer than that of the side frame side and there is thus a step, the second sharp end is configured to have a shape connecting the step with a slope.

8. The electronic device of claim 3, wherein in the conductive member having the predetermined width,
the first sharp end is configured to have the predetermined width in a partial area of the conductive member and to gradually decrease while forming a predetermined angle so that a width thereof becomes 0.

9. The electronic device of claim 3, wherein in the conductive member having the predetermined width,
the second sharp end is configured to have the predetermined width in a partial area of the conductive member and to gradually decrease while forming a predetermined angle so that a width thereof becomes 0.

10. The electronic device of claim 1, wherein the conductive member further comprises a bridge area facing the side frame.

11. The electronic device of claim 10, wherein the bridge area further comprises a third sharp end facing the side frame.

12. The electronic device of claim 1, wherein the side frame further comprises a triangular or pointed sharp end area facing the flexible display.

13. The electronic device of claim 12, wherein the conductive member further comprises a bridge area including a third sharp end facing the side frame, and
the sharp end area is configured to correspond to the bridge area.

14. The electronic device of claim 1, wherein the conductive member is deposited and/or plated to be disposed at the protection cover.

15. The electronic device of claim 11, wherein the conductive member is disposed at the protection cover with an adhesive tape.
